# EUROPEAN PATENT SPECIFICATION

(11) **EP 0 523 730 B1**
(45) Date of publication and mention of the grant of the patent: **10.06.1998**
(21) Application number: 92112258.6
(22) Date of filing: 17.07.1992
(51) Int. Cl.: H01B 11/18, H01L 23/49, H01L 21/60

(54) **Coaxial wire for bonding semiconductors and a method of its manufacure**
Koaxialdraht zum Kontaktieren von Halbleitern und dessen Herstellungsverfahren
Fil coaxial pour le bonding de semi-conducteurs et un procédé de son fabrication

(30) Priority: 17.07.1991 GB 9115462
(43) Date of publication of application: 20.01.1993
(73) Proprietor: LSI LOGIC CORPORATION, Milpitas, CA 95035 (US)
(72) Inventor: Miaoulis, Niko, Gravesend, Kent DA11 9NB (GB)
(74) Representative: Kahler, Kurt, Dipl.-Ing.

(56) References cited:
- EP-A- 0 183 598
- US-A- 4 525 383
- US-A- 4 581 291
- US-A- 4 956 749

## Description

The invention relates to improved bonding wires, and is particularly concerned with bonding wires for use in microelectronic assemblies and similar applications.

There are various ways of making connections from a chip carrier or package to a semiconductor (microelectronic) device (die), among which are wire bonding. The bond wires extend from the die to a lead frame, or to inner ends of lead fingers in a package, and carry power, ground and signals to and from the semiconductor die.
Typically, there are many closely-spaced bond wires extending from the die to the lead-frame (or package). Each bond wire is "small", namely on the order of 0.025 mm (one thousandth of an inch), or less, in diameter. As semiconductor devices become faster and faster, the signals carried by the wires become higher and higher in frequency.

In the connection of components in microelectronic assemblies and other similar applications, it is desirable to reduce the mutual inductance of the bond wires - in other words, the "cross-talk" between closely adjacent bond wires, particularly those bond wires carrying signals, especially higher frequency signals, to and from the semiconductor device. At the high operating speeds of modern semiconductor devices, this becomes a non-trivial problem. The same problem can manifest itself in other, similar applications.

In US-A-4,581,291 a microminiature coaxial cable is disclosed having a ribbon inner conductor surrounded by a dielectric polystyrene or parylene and a circumferential conductor aluminium or copper.

In EP-A-0 465 113, filed June 26, 1991, published January 8, 1992, a coaxial cable is disclosed which comprises an inner conductor consisting of a very fine metal wire having a diameter of 120 µm or below an insulating layer of an insulating synthetic resin material or teflon coating the inner conductor and an outer conductor Cu or Ag coating the insulating layer.

In US-A-4 956 749 a semiconductor integrated device support structure having a transmission line interconnected structure in a metal block on which the devices are mounted is disclosed. A plurality of stacked layers contains the complete wireline interconnection network. Each wire has an inner conductor, surrounded by a dielectric material, for which silicone or teflon is proposed, and an outer conductor.

It is therefore an object of the present invention to provide an improved bond wire which manifests less mutual inductance, especially with respect to neighboring bond wires. The improved bond should be formable by an improved method.

According to the present invention, a small diameter conductive wire as in claim 1 is provided with a first coating of an electrically insulating material, and is further provided with a second coating of electrically conductive material superposed over the first insulating material. In this manner, a "small" coaxial wire is formed, having a conductive "core", an intermediate insulating layer, and an outer conductive layer.

The first coating is formed of silicon dioxide and the second coating is formed of doped silicon to facilitate the process.

The invention further describes a method of producing such a coaxial wire - namely, the techniques for treating the initial wire which serves as the core of the coaxial wire.

The invention is especially well-suited to semiconductor applications, as a bond wire extending between a semiconductor die and a lead frame or package leads. By reducing the mutual inductance of the bond wires, signals, especially higher frequency signals, can be conveyed by the wires, with less interference from signals on neighboring wires.

The application of the second, electrically conductive layer of doped silicon over the intermediate insulting layer formed of silicon dioxide effectively makes each bond wire a miniature coaxial conductor.

### DRAWINGS

Figure 1 is a cross-sectional view of a bond wire, according to the prior art.

Figure 2 is a cross-sectional view of a bond wire, such as that set forth in Figure 1, provided with a first overlying layer (coating) of SiO₂, according to the present invention.

Figure 3 is a cross-sectional view of the bond wire of Figure 2, further provided with a second overlying layer (coating) of doped silicon according to the present invention.

Figure 4 is a perspective view of a bond wire, being formed according to an alternate embodiment of the present invention.

Figure 5 is a perspective view of the completed bond wire of Figure 4, according to the present invention.

### DESCRIPTION

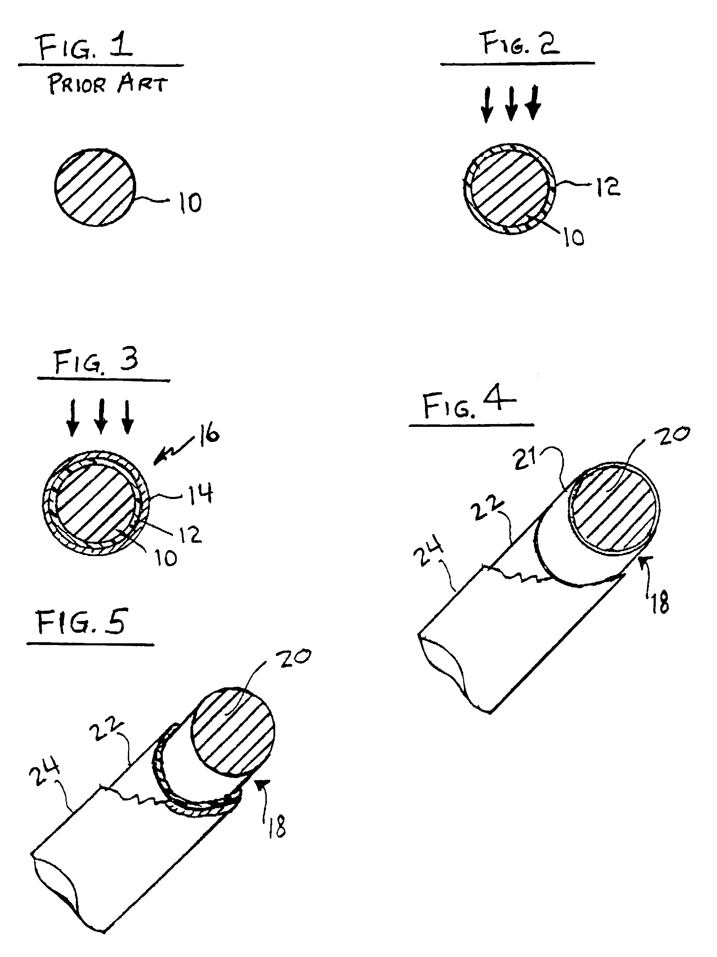

Figure 1 shows a cross-section of a conductive bond wire 10, formed of a material such as gold, copper or the like. The bond wire has a diameter in the order of 0.025 mm (one thousandth of an inch), or less, and is suitable for bonding from the bond pads (not shown) of a semiconductor device (die) to a lead frame, or the like. The use of many such "small" bond wires is well known for connecting semiconductor chips (dies), and is known to provide some sort of insulation, such as a gel, over the bond wires to prevent their shorting to one another.

According to the present invention, bond wires are made into miniature coaxial conductors. This can occur prior to being bonded to the die, or after, the latter (after) being somewhat preferable. (If overcoated before bonding to the die, the intermediate insulating layer and outermost conductive layer must be "stripped away" at the location of bonding.)

Figure 2 shows a small conductive wire, such as the bond wire 10 of Figure 1, being treated. In this case, there is a "core" conductor 10. Arrows (↓↓↓) indicate a processing step, wherein the bond wires are covered with a layer of silicon dioxide as an electrically insulating material. The insulating material can be applied using any one of various methods, for example an electron cyclotron resonance plasma process, or a pulsed plasma process. Further, if this step is performed after the core 10 is bonded to the die, surrounding areas of the die can be covered with the insulating material in this same step. As will be seen, the insulating layer 12 is used as an "intermediate" layer, according to the present invention.

Turning to Figure 3, after the insulating layer 12 has been applied, an electrically conductive outer layer (or coating) 14 is formed over the insulating layer. This electrically conductive coating (layer) 14 is of doped silicon. This layer 14 can be deposited using a similar process as was used in forming the intermediate layer 12 - namely an electron cyclotron resonance plasma process, or a pulsed plasma process.

Hence, the completely formed wire, shown as 16 in Figure 3, is effectively a miniature coaxial conductor, suitable for making connections to semiconductor dies.

Figures 4 and 5 show an alternate embodiment of the invention.

In Figure 4, an area 18, such as an end of a conductor 20 (similar to conductor 10) is "masked", in other words covered with a masking material 21, prior to applying an insulating layer 22. The insulating layer 22, similar to the insulating layer 12, is applied over the wire 20 and over the mask 21, in a manner similar to that described with respect to Figure 2. The partially formed coaxial conductor (core 20 and insulating layer 22) is then further processed similar to Figure 3, to provide an outer conductive layer 24 overlying the intermediate insulating layer 22. The mask 21 may then be removed, exposing the core 20 in the masked area 18, as shown in Figure 5.

This technique of masking is especially suited to forming a coaxial wire for bonding, prior to bonding, and without requiring stripping away outer insulating and conductive layers.

Preferably, the outer conductive layer 14 (or 24) can be connected to a ground plane associated, for example, with a package containing the semiconductor die. This can be achieved by wire bonding (such as by using another wire) from the ground plane to the outer layer (14 or 24).

The miniature coaxial conductor of the present invention provides a capability of carrying higher frequency signals to and from a semiconductor device, without cross-talk from adjacent (neighboring) signal-carrying wires. Preferably, all of the signal-carrying wires associated with a semiconductor die are formed as miniature coaxial conductors (cables). Additionally, shorts between adjacent bonding wires are alleviated, due to the insulating feature of the insulating layer.

As noted above, the diameter of the core (10, 20) is on the order of 0.025 mm (one thousandth of an inch, 25 microns), or less. The thickness of the intermediate insulating layer (12,22) is on the order of a few µm (microns), or less. The thickness of the outer conductive layer (14,24) is also on the order of a few µm (microns), or less. Hence, the overall diameter of the coaxial conductor (16) is not significantly increased over that of a bare bonding wire.

## Claims

1. Miniature coaxial cable, comprising:
an inner conductive core (10, 20);
an insulating layer (12, 22) deposited onto the core (10, 20); and
an outer conductive layer (14, 24) formed over the insulating layer (12; 22)
**characterized** in
that the insulating layer (12, 22) is formed of silicon dioxide and
that the outer layer (14, 24) is formed of doped silicon.

2. Miniature coaxial cable according to claim 1, wherein said inner conductive core (10, 20) is on the order of 0.025 mm (one thousandth of an inch), or less, in diameter.

3. Miniature coaxial cable according to claim 1 or 2, wherein the core (10, 20) is formed of gold.

4. Miniature coaxial cable according claim 1 to 3, further comprising:
an area (18) along the core (20) where the core is exposed; and
the remaining core being covered with the insulating layer and the outer conductive layer.

5. Method of forming a bond wire for bonding semiconductor dies said bond wire consisting of a miniature coaxial cable as set forth in claims 1 to 4, comprising the steps of:
(a) providing the core conductor (10, 20);
(b) forming the intermediate insulating layer (12, 22) over the core conductor (10, 20); and
(c) forming the outer conductive layer (14, 24) over the intermediate insulating layer (12, 22), wherein the bond wires are in place and connected between the die bond pads and the leadframe before the step of forming said intermediate insulating layer (12, 22).

6. Method according to claim 5,
wherein the intermediate layer (12, 22) is formed using an electron cyclotron resonance plasma process.

7. Method according to claim 5,
wherein the intermediate layer (12, 22) is formed using pulsed plasma deposition.

8. Method according to claim 5,
wherein the outer layer (14, 24) is formed using an electron cyclotron resonance plasma process.

9. Method according to claim 5,
wherein the outer layer (14, 24) is formed using pulsed plasma deposition.

## Patentansprüche

1. Miniaturkoaxialkabel, aufweisend:
einen inneren leitenden Kern (10, 20);
eine Isolierschicht (12, 22), die auf dem Kern (10, 20) aufgebracht ist; und
eine äußere leitende Schicht (14, 24), die über der Isolierschicht (12, 22) ausgebildet ist,
dadurch **gekennzeichnet**,
daß die Isolierschicht (12, 22) aus Siliziumdioxid gebildet ist und
daß die äußere Schicht (14, 24) aus dotiertem Silizium gebildet ist.

2. Miniaturkoaxialkabel nach Anspruch 1,
wobei der innere leitende Kern (10, 20) im Durchmesser in der Größenordnung von 0,025 mm (ein Tausendstel eines Inchs) oder geringer ist.

3. Miniaturkoaxialkabel nach Anspruch 1 oder 2,
wobei der Kern (10, 20) aus Gold gebildet ist.

4. Miniaturkoaxialkabel nach Anspruch 1 bis 3, ferner aufweisend:
einen Bereich (18) entlang des Kerns (20), wo der Kern freigelegt ist; und wobei
der verbleibende Kern mit der Isolierschicht und der äußeren leitenden Schicht bedeckt ist.

5. Verfahren zur Herstellung eines Kontaktdrahts zum Kontaktieren von Halbleiterplättchen, wobei der Kontaktdraht aus einem Miniaturkoaxialkabel besteht, wie in Ansprüchen 1 bis 4 dargelegt ist,
die Schritte aufweisend:
(a) Vorsehen des Kernleiters (10, 20);
(b) Ausbilden der Zwischenisolierschicht (12, 22) über dem Kernleiter (10, 20); und
(c) Ausbilden der äußeren leitenden Schicht (14, 24) über der Zwischenisolierschicht (12, 22),
wobei die Kontaktdrähte vor dem Schritt des Ausbildens der Zwischenisolierschicht (12, 22) in Position sind und zwischen den Plättchenkontaktstellen und dem Leiterrahmen verbunden sind.

6. Verfahren nach Anspruch 5,
wobei die Zwischenschicht (12, 22) unter Verwendung eines Elektron-Zyklotron-Resonanz-Plasma-Verfahrens ausgebildet ist.

7. Verfahren nach Anspruch 5,
wobei die Zwischenschicht (12, 22) unter Verwendung einer gepulsten Plasmaabscheidung ausgebildet ist.

8. Verfahren nach Anspruch 5,
wobei die äußere Schicht (14, 24) unter Verwendung eines Elektron-Zyklotron-Resonanz-Plasma-Verfahrens ausgebildet ist.

9. Verfahren nach Anspruch 5,
wobei die äußere Schicht (14, 24) unter Verwendung einer gepulsten Plasmaabscheidung ausgebildet ist.

## Revendications

1. Câble coaxial miniature, comprenant :
une âme conductrice intérieure (10, 20),
une couche isolante (12, 22) déposée sur l'âme, et
une couche conductrice extérieure (14, 24) formée sur la couche isolante (12, 22),
caractérisé en ce que
la couche isolante (12, 22) est formée de dioxyde de silicium, et
la couche extérieure (14, 24) est formée de silicium dopé.

2. Câble coaxial miniature selon la revendication 1, dans lequel ladite âme conductrice intérieure (10, 20) est d'un diamètre de l'ordre de 0,025 mm (un millième de pouce) ou moins.

3. Câble coaxial miniature selon la revendication 1 ou 2, dans lequel l'âme (10, 20) est formée d'or.

4. Câble coaxial miniature selon les revendications 1 à 3, comprenant en outre:
une zone (18) le long de l'âme (20) où l'âme est exposée, et
l'âme restante étant recouverte de la couche isolante et de la couche conductrice extérieure.

5. Procédé de formation d'un fil de liaison destiné à relier des puces de semiconducteur, ledit fil de liaison étant constitué d'un câble coaxial miniature selon les revendications 1 à 4, comprenant les étapes consistant à :
(a) fournir le conducteur de l'âme (10, 20),
(b) former la couche isolante intermédiaire (12, 22) sur le conducteur de l'âme (10, 20), et
(c) former la couche conductrice extérieure (14, 24) sur la couche isolante intermédiaire (12, 22),
dans lequel les fils de liaison sont en place et reliés entre les plots de liaison des puces et l'araignée de connexions avant l'étape consistant à former ladite couche isolante intermédiaire (12, 22).

6. Procédé selon la revendication 5,
dans lequel la couche intermédiaire (12, 22) est formée en utilisant un processus au plasma à résonance cyclotron d'électrons.

7. Procédé selon la revendication 5,
dans lequel la couche intermédiaire (12, 22) est formée en utilisant un dépôt au plasma pulsé.

8. Procédé selon la revendication 5,
dans lequel la couche extérieure (14, 24) est formée en utilisant un processus au plasma à résonance cyclotron d'électrons.

9. Procédé selon la revendication 5,
dans lequel la couche extérieure (14, 24) est formée en utilisant un dépôt au plasma pulsé.
